# EUROPÄISCHE PATENTSCHRIFT

(11) **EP 2 986 894 B1**
(45) Veröffentlichungstag und Bekanntmachung des Hinweises auf die Patenterteilung: **31.05.2017**
(21) Anmeldenummer: 14726497.2
(22) Anmeldetag: 25.03.2014
(51) Int. Cl.: F21S 8/06, F21S 4/28, F21Y 107/90, F21Y 105/12, F21Y 115/10

(54) **LEITERPLATTE FÜR EINE LEUCHTE**
PRINTED CIRCUIT BOARD FOR A LAMP
CARTE DE CIRCUIT IMPRIMÉ POUR LAMPE

(30) Priorität: 28.03.2013 AT 1022013 U; 25.04.2013 AT 1422013 U
(43) Veröffentlichungstag der Anmeldung: 24.02.2016
(73) Patentinhaber: Zumtobel Lighting GmbH, 6850 Dornbirn (AT)
(72) Erfinder: PÖHS, Mario, A-6850 Dornbirn (AT)
(74) Vertreter: Zumtobel Group IP Management
(86) Internationale Anmeldenummer: PCT/AT2014/000053
(87) Internationale Veröffentlichungsnummer: WO 2014/153579

(56) Entgegenhaltungen:
- WO-A2-2013/021311
- DE-U1-202010 008 479
- US-A1- 2011 193 105
- US-B1- 6 483 439

## Beschreibung

Die Erfindung betrifft eine Leiterplatte für eine Leuchte sowie eine Leuchte mit einer solchen Leiterplatte. Gegenwärtig werden immer häufiger Leuchten zur Allgemeinbeleuchtung mit Leuchtdioden als Leuchtmittel ausgestattet. Um hierzu geeignet zu sein, werden eine Vielzahl von Leuchtdioden verwendet, die in Serie miteinander verschaltet sind. Außerdem ist es bekannt bei Bedarf mehrere Schaltungszweige mit Leuchtdioden parallel zueinander zu verschalten.

Oftmals besteht die Anforderung an Leuchten, dass diese ihr Licht direkt und indirekt abgeben können. Direkt gibt eine Leuchte ihr Licht ab, wenn das Licht unmittelbar auf die zu beleuchtende Fläche abgestrahlt wird und indirekt, wenn das Licht in Richtung einer reflektierenden Fläche, also üblicherweise einer Wand oder Decke abgestrahlt wird und von dort zum eigentlich zu beleuchtenden Bereich gelenkt wird. Hierbei ist es aus dem Stand der Technik bekannt separate Lichtmodule mit Leuchtdioden für den direkten und für den indirekten Teil des Lichtes vorzusehen. Diese Module werden in der Regel von unterschiedlichen Betriebsgeräten versorgt oder es ist ein Teil der parallel geschalteten Schaltungszweige für die indirekte Beleuchtung und der andere Teil der Schaltungszweige für die direkte Beleuchtung vorgesehen. Es liegt auf der Hand, dass das Betreiben der Lichtmodule mit unterschiedlichen Betriebsgeräten aufwendig in der Verdrahtung und hinsichtlich des Raumbedarfs ist. Weniger offensichtlich ist das Problem, welches entsteht, wenn parallel geschaltete Schaltungszweige zur Aufteilung des direkten und indirekten Anteils genutzt werden.

Damit in den Schaltungszweigen ein klar definierter Strom fließt, der Voraussetzung für eine gleichmäßige Belastung der Leuchtdioden ist, ist es zwingend notwendig ausschließlich Leuchtdioden des gleichen Spannungsbins zu verwenden. Unter Binning wird das Sortieren von Leuchtdioden entsprechend abgestufter Parameter wie Farbtemperatur, Helligkeit, Vorwärtsspannung (Spannungsbinning) usw. verstanden. Dies ist notwendig um mit fertigungsbedingten Abweichungen in den Parametern der Leuchtdioden so umzugehen, dass diese beim Betrieb der Leuchtdioden nicht nachteilig zum Tragen kommen. Verständlicherweise führt Binning zu einem zusätzlichen logistischem Aufwand.

Werden Leiterplatten für Leuchten beidseitig, d.h. auf deren Vorder- und deren Rückseite, mit Leuchtdioden bestückt ergibt sich ein weiteres Problem. Im Herstellungsprozess wird in der Regel in einem ersten Arbeitsschritt die Vorderseite mit Leuchtdioden bestückt und in einem zweiten Arbeitsschritt die Rückseite. Liegen die Schaltungszweige mit den Leuchtdioden der Vorderseite parallel zu den Leuchtdioden der Rückseite, so bedingt dies, wie zuvor ausgeführt, die Verwendung von Leuchtdioden des gleichen Spannungsbins auf der Vorder- und der Rückseite. Es muss daher im Herstellungsprozess sichergestellt werden, dass nicht alle Leuchtdioden eines Spannungsbins bei der Bestückung der ersten Seite verbraucht werden.

US 6,843,439 B1 zeigt eine Leiterplatte nach dem Oberbergriff des Anspruchs 1. Der Erfindung liegt die Aufgabe zugrunde eine Leiterplatte für Leuchten so auszuführen, dass die zuvor genannten Nachteile insbesondere des Binnings minimiert sind. Außerdem soll eine größere Flexibilität bei der Auswahl der Leuchtdioden ermöglicht werden.

Die Aufgabe wird gelöst durch eine Leiterplatte mit den Merkmalen des Anspruchs 1. Erfindungsgemäß ist eine erste Anzahl Leuchtdioden eines Schaltungszweiges auf einer Vorderseite der Leiterplatte und eine zweite Anzahl Leuchtdioden des selben Schaltungszweiges auf einer Rückseite der Leiterplatte angebracht. Vorzugsweise sind die Leuchtdioden eines Schaltungszweiges vom selben Typ. Die Leuchtdioden der Vorderseite können aber gegenüber den Leuchtdioden der Rückseite aus einem anderen Spannungsbin stammen. Wird die Leiterplatte in Leuchten für die Allgemeinbeleuchtung eingesetzt, so werden bevorzugt Leuchtdioden verwendet, die weißes Licht abstrahlen. Außerdem können Leuchtdioden unterschiedlicher Bauart verwendet werden. Beispielsweise können in einer Ausführungsform die Leuchtdioden der Vorderseite als sogenannte 1-Chip LED mit einer Vorwärtsspannung von 3 Volt und die Leuchtdioden der Rückseite mit 2-Chip LED mit interner Serienverschaltung der Chips eingesetzt werden. Die Kombination dieser Leuchtdioden ermöglicht neben der Verwendung von Leuchtdioden aus unterschiedlichen Spannungsbins einen weiteren Freiheitsgrad bei der Festlegung der Anteile für Direkt- und Indirektlicht.

Die Ansprüche 2 bis 6 betreffen vorteilhafte Ausgestaltungen der Erfindung insbesondere in Hinblick auf die Anzahl und Anordnung der Leuchtdioden.

Gemäß Anspruch 7 ist in einer Weiterbildung der Erfindung vorgesehen, dass einzelne Leuchtdioden oder Gruppen von Leuchtdioden mittels Null-Ohm-Widerständen überbrückbar sind, wobei hierfür auf der Leiterplatte elektrische Kontaktflächen zur Kontaktierung der Widerstände vorgesehen sind. Insbesondere dann, wenn die Leuchtdioden der Rückseite überbrückt werden, ist auf einfache Arte und Weise eine Mehrfachnutzung der erfindungsgemäßen Leiterplatte möglich, weil eine einseitig bestückte Leiterplatte auch in Leuchte zur Anwendung gelangen kann, die Licht nur direkt abstrahlen. Hier ist zu vermerken, dass die Null-Ohm-Widerstände vorteilhaft auf der Vorderseite angebracht werden, wenn die Leuchtdioden der Rückseite überbrückt werden sollen (was in der Praxis bedeutet, dass diese Weggelassen werden), weil dann im Herstellungsprozess nur eine Seite der Leiterplatte bestückt werden muss.

In einer weiteren Ausgestaltung der Erfindung, sind erste Gruppen von Leuchtdioden von Schaltungszweigen, welche das gleiche Spannungspotential aufweisen, in Clustern zur Abstrahlung ihres Lichtes in eine gemeinsame Optik angeordnet sowie zweite Gruppen von Leuchtdioden von Schaltungszweigen, welche ein Spannungspotential aufweisen, welches sich im Wesentlichen um die Vorwärtsspannung einer einzigen verwendeten Leuchtdioden vom Spannungspotential der ersten Gruppe unterscheidet, gemeinsam mit Leuchtdioden der ersten Gruppe in Clustern zur Abstrahlung ihres Lichtes in eine gemeinsame Optik angeordnet. Diese Anordnung der Leuchtdioden in Clustern führt dazu, dass im Fehlerfalle einer einzigen der Leuchtdioden immer noch Licht von den übrigen Leuchtdioden des Clusters in die gemeinsame Optik abgegeben wird und somit die Grundfunktion der Leuchte erhalten bleibt.

Als Optik können Linsen, Lichtleiter oder Reflektoren und Kombinationen aus diesen Elementen verwendet werden.

Die Erfindung betrifft auch eine Leuchte gemäß Anspruch 12 mit wenigstens einer erfindungsgemäßen Leiterplatte. Besonders vorteilhaft können die erfindungsgemäße Leiterplatten in Leuchten entsprechend Anspruch 13 mit direkter und indirekt Lichtabgabe eingesetzt werden.

Es zeigen
- Fig. 1: eine perspektivische Ansicht einer erfindungsgemäßen Leuchte,
- Fig. 2: den Querschnitt durch eine erfindungsgemäße Leuchte nach Fig. 1,
- Fig.3: einen Schaltplan, der die elektrische Verschaltung der Leuchtdioden auf einer erfindungsgemäßen Leiterplatte wiedergibt,
- Fig. 4: die Vorderansicht einer erfindungsgemäßen Leiterplatte,
- Fig. 5: die Rückansicht der erfindungsgemäßen Leiterplatte nach Fig. 4.

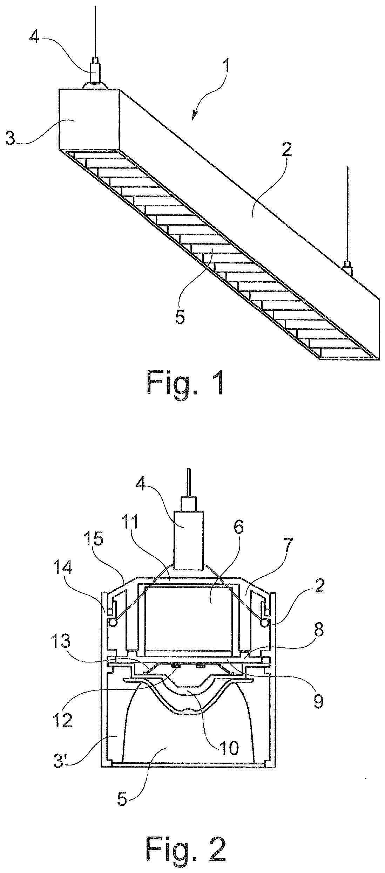

Die Figur 1 zeigt eine Leuchte (1), welche als Pendelleuchte ausgeführt ist. Die Leuchte (1) weist ein Gehäuse mit Seitenwänden (2) sowie Stirnteilen (3) auf. Licht wird über einen Raster (5), welcher als Kunststoffzellenraster ausgeführt ist, von der Leuchte (1) abgegeben. Die Leuchte (1) ist mit sogenannten Seilpendeln (4) an einer Decke (nicht dargestellt) montiert.

In Figur 2 ist eine erfindungsgemäße Leuchte (1) in der Ausführungsform nach Figur 1 dargestellt. Es ist erkennbar, dass neben der direkten Lichtabgabe über den Raster (5) auch Licht über die Abdeckung (11) zur einer (nicht dargestellten) Decke abgestrahlt wird. Hierzu sind auf einer Leiterplatte (9) Leuchtdioden (8) angeordnet, welche so angeordnet sind, dass sie ihr Licht in unmittelbar über ihnen angeordnete Lichtleiter (7) einstrahlen. Dieses Licht wird im Lichtleiter (7) zu der Abdeckung (11) geleitet und von dort über eine Abstrahlfläche in die Umgebung abgegeben. Die Abdeckung (11) bildet zusammen mit den Lichtleitern (7) im Querschnitt gesehen eine U-Form aus einem Quersteg und Seitenflanken, wobei die Abdeckung (11) die Lichtleiter (7) seitlich überragt. Hierdurch sind Vorsprünge (15) gebildet, die gegenüber der Ebene in der die Abdeckung (11) liegt, abgewinkelt angeordnet sind. Diese Abwinkelung hat den vorteilhaften Effekt zur Folge, dass die Abstrahlung des Lichts aufgeweitet wird und somit ein größerer Bereich der (nicht dargestellten) Decke beleuchtet wird als dies der Fall wäre, wenn die Abwinkelung nicht vorhanden wäre. Die Abdeckung (11) sowie die Lichtleiter (7) bzw. der Quersteg, die Seitenflanken und die Vorsprünge (15) sind als Kunststoffprofil ausgebildet und formen so eine Baueinheit. Diese Baueinheit wird als Ganzes mit den Seitenwänden (2) des Leuchtengehäuses verbunden. Hierzu weist die Baueinheit am Ende der Vorsprünge (15) Schnappleisten (14) auf, die jeweils in zugeordnete erste Nuten der Seitenwände eingeschnappt sind.

Die Leiterplatte (9) ist beidseitig mit Leuchtdioden (8, 12) bestückt. Die Leuchtdioden (12), welche der Direktbeleuchtung dienen, sind von einem Linsenprofil (10) überdeckt, welche ebenso wie die Leiterplatte (9) selbst in zweite Nuten, welche an den Seitenwänden angeformt sind, gehalten werden. Das von den Leuchtdioden (12) über das Linsenprofil (10) in den Zellenraster (5) abgestrahlte Licht wird von diesem Raster (5) so umgelenkt, dass die Leuchte (1) entblendet ist und die einschlägigen Normen für Arbeitsplatzbeleuchtung erfüllt. Zur Verbesserung der Effizienz ist seitlich neben den Leuchtdioden (12) ein Reflektor (13) angeordnet, welcher dafür sorgt, dass möglichst ein Großteil des Lichts der Leuchtdioden (12) in Richtung des Linsenprofils (10) abgestrahlt wird.

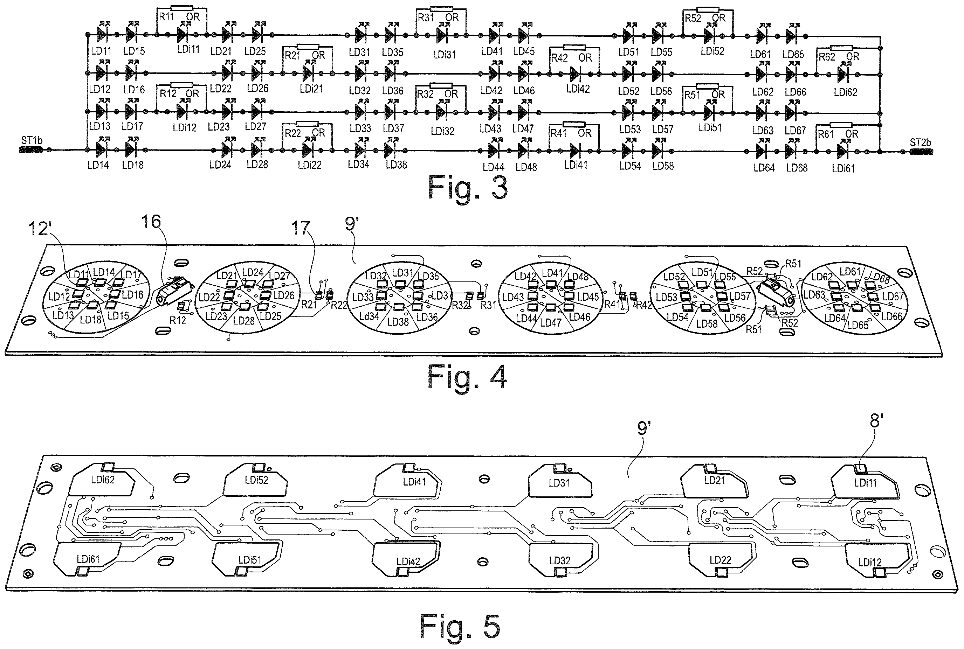

Die in Figur 2 nur schematisch dargestellte Leiterplatte (9) und die nur schematisch dargestellte Leuchtdioden (8, 12) werden in den Figuren 3, 4 und 5 als Leiterplatte (9') bzw. als Leuchtdioden (8', 12') bezeichnet. Die Leuchtdioden (12') eines Schaltungszweiges sind in Serienschaltung angeordnet und weisen in einem ersten Schaltungszweig die Bezeichnungen LD11, LD15, LD21, LD25, LD31 LD35, LD41, LD45, LD51, LD55, LD61, LD65 sowie LDi11, LDi31, LDi52 auf. Die Leuchtdioden (12') mit der Bezeichnung LD11, LD15, LD21, LD25, LD31 LD35, LD41, LD45, LD51, LD55, LD61, LD65, welche auf der in Figur 4 dargestellten Vorderseite der Leiterplatte (9') angebracht sind, dienen der Direktbeleuchtung und die Leuchtdioden (8') mit der Bezeichnung LDi11, LDi31, LDi52, welche auf der in Figur 5 dargestellten Rückseite der Leiterplatte (9') angebracht sind dienen der Indirektbeleuchtung. Zur Klarstellung sei vermerkt, dass aus Gründen der Übersichtlichkeit in dieser Beschreibung und in den Ansprüchen in der Regel immer nur auf die Leuchtdioden des ersten Schaltungszweiges referenziert wird und auf die Auflistung der übrigen Leuchtdioden verzichtet wird.

Aus der Figur 3 ist ersichtlich, dass vier Schaltungszweige mit jeweils fünfzehn Leuchtdioden parallel zueinander verschaltet sind. Diese Schaltungsanordnung wird in einem bevorzugten Ausführungsbeispiel mit einer Spannung von 40 bis 46 Volt (typisch 43,7 Volt, 12,2 Watt) beaufschlagt, was zu einem Gesamtstrom im einzelnen Schaltungszweig von 70 Milliampere bzw. von 280 Milliampere für die gesamte Schaltungsanordnung gemäß Figur 3 führt. Für eine Leuchte in der Art der Figur 1 werden vorzugsweise vier Leiterplatten mit einer Schaltungsanordnung entsprechend Figur 3 verwendet, wobei die Leiterplatten in Serie geschaltet sind. Zum Betreiben dieser Schaltungsanordnung kann daher ein Konverter verwendet werden, der eine Ausgangsspannung von 160 - 184 Volt und einen Konstantstrom von 280 Milliampere (das entspricht typisch 49 Watt) liefert.

Zum Verständnis der Schaltung ist noch anzumerken, dass die Null-Ohm-Widerstände mit der Bezeichnung R11, R31, R52 nicht bestückt sind, wenn die Leuchtdioden LDi11, LDi31, LDi52 bestückt sind und umgekehrt.

Die Figur 4 zeigt in perspektivischer Darstellung im Wesentlichen die Vorderseite einer erfindungsgemäßen Leiterplatte. Auf der Leiterplatte (9') sind insgesamt sechs Cluster mit jeweils acht in einem quadratischen Muster angeordnete Leuchtdioden platziert. Beispielhaft seien die Leuchtdioden LD11 bis LD18 erwähnt, die ein erstes Cluster mit acht Leuchtdioden bilden.

Wie aus dem Schaltplan gemäß Figur 3 in Verbindung mit Figur 4 ersichtlich ist, sind in einem ersten Abschnitt der leiterplatte (9') jeweils zwei Leuchtdioden, nämlich LD11 mit LD15, LD12 mit LD16, LD13 mit LD17 und LD14 mit LD18 in Serie zu einander geschaltet und bilden auf diese Weise ein Gruppe von jeweils zwei Leuchtdioden. Diese Serienschaltung von zwei Leuchtdioden liegt jeweils auf dem selben Spannungspotential, denn jede dieser Gruppen befindet sich in einem der vier parallel geschalteten Schaltungszweige.

Die quadratische Anordnung der Leuchtdioden in den zuvor erwähnten Clustern ermöglicht es nun, vor bzw. neben den Leuchtdioden eine Optik vorzusehen, die alles Licht, welches von den Leuchtdioden abgegeben wird aufnimmt und entsprechend ihrer optischen Eigenschaften leitet bzw. lenkt. Beispielsweise ist in Figur 2 eine solche Optik gezeigt, die durch einen Reflektor (13) und eine Linsenoptik (10) realisiert ist, wobei ein vorgesetzter Reflektor (5) die Lichttechnik zusätzlich weiter verbessert. Anstelle einer quadratischen Anordnung der einen Cluster bildenden Leuchtdioden sind auch andere insbesondere geometrische Muster, wie beispielsweise Kreise, Sechsecke und so weiter denkbar.

Jeweils zwei Leuchtdioden, nämlich LD21 mit LD25, LD22 mit LD26, LD23 mit LD27 und LD24 mit LD28, des zweiten Clusters sind in Serie miteinander geschaltet, allerdings liegen nur die Leuchtdioden LD21 mit LD25 und LD23 mit LD27 auf dem selben Spannungspotential, denn das Spannungspotential der Leuchtdioden LD22 mit LD26 und LD24 mit LD28 unterscheidet sich von den zuvor genannten Gruppen von Leuchtdioden durch den Spannungsabfall, der durch die Leuchtdioden LDi11 bzw. LDi12 verursacht wird. Hinsichtlich der räumlichen Anordnung bzw hinsichtlich der Anordnung als Muster unterscheidet sich jedoch der zweite Cluster von Leuchtdioden nicht vom ersten Cluster.

Auf der Leiterplatte (9') sind ferner eine Eingangsklemme (16) und eine Ausgangsklemme angeordnet. Außerdem sind die Null-Ohm-Widerstände (17) dargestellt, wobei nochmals darauf verwiesen wird, dass die Leiterplatte (9') mit diesen nur dann bestückt ist, wenn auf der Rückseite der Leiterplatte (9') keine Leuchtdioden angeordnet werden und die Leiterplatte demnach zum Einsatz in einer Leuchte mit reiner Direktbeleuchtung vorgesehen ist.

In Figur 5 ist die Rückseite der Leiterplatte (9') in perspektivischer Darstellung gezeigt. Die insgesamt zwölf Leuchtdioden (8') sind in zwei Reihen entlang seitlicher Randbereiche der Leiterplatte (9') angeordnet. Die räumliche Verteilung dieser Leuchtdioden (8') auf der Leiterplatte (9') erfolgt in der Weise , dass nebeneinander nur Leuchtdioden liegen, welche nicht im gleichen Schaltungszweig angeordnet sind. Der Ausfall einzelner Leuchtdioden stört hierdurch weniger.

## Patentansprüche

1. Leiterplatte für eine Leuchte,
aufweisend mehrere Schaltungszweige mit einer Vielzahl von Leuchtdioden, wobei die Leuchtdioden eines Schaltungszweiges jeweils in Serie zueinander verschaltet sind und die Schaltungszweige zueinander parallel geschaltet sind, wobei eine erste Anzahl Leuchtdioden (LD11, LD15, LD21, LD25, LD31 LD35, LD41, LD45, LD51, LD55, LD61, LD65) eines Schaltungszweiges auf einer Vorderseite der Leiterplatte und eine zweite Anzahl Leuchtdioden (LDi11, LDi31, LDi52) des selben Schaltungszweiges auf einer Rückseite der Leiterplatte angebracht sind, wobei die Leuchtdioden (LD11, LD15, LD21, LD25, LD31 LD35, LD41, LD45, LD51, LD55, LD61, LD65) eines Schaltungszweiges vom selben Typ sind, **dadurch gekennzeichnet, dass** die Leuchtdioden (LD11, LD15, LD21, LD25, LD31 LD35, LD41, LD45, LD51, LD55, LD61, LD65) der ersten Anzahl ein von den Leuchtdioden (LDi11, LDi31, LDi52) der zweiten Anzahl unterschiedliches Spannungsbin aufweisen.

2. Leiterplatte nach Anspruch 1,
**dadurch gekennzeichnet,**
**dass** die Anzahl der Leuchtdioden (LD11, LD15, LD21, LD25, LD31 LD35, LD41, LD45, LD51, LD55, LD61, LD65), welche auf der Vorderseite der Leiterplatte angebracht sind ungleich der Anzahl der Leuchtdioden (LDi11, LDi31, LDi52) ist, welche auf der Rückseite angebracht sind.

3. Leiterplatte nach Anspruch 1 oder 2,
**dadurch gekennzeichnet,**
**dass** die Anzahl der Leuchtdioden (LD11, LD15, LD21, LD25, LD31 LD35, LD41, LD45, LD51, LD55, LD61, LD65), welche auf der Vorderseite der Leiterplatte angebracht sind, größer ist, als die Anzahl der Leuchtdioden (LDi11, LDi31, LDi52), welche auf der Rückseite angebracht sind.

4. Leiterplatte nach einem der vorigen Ansprüche,
**dadurch gekennzeichnet,**
**dass** das Verhältnis der Anzahl der Leuchtdioden (LD11, LD15 LD21, LD25, LD31 LD35, LD41, LD45, LD51, LD55, LD61, LD65), welche auf der Vorderseite der Leiterplatte angebracht sind, zur Anzahl der Leuchtdioden (LDi11, LDi31, LDi52), welche auf der Rückseite angebracht sind, 4:1 beträgt.

5. Leiterplatte nach einem der vorigen Ansprüche,
**dadurch gekennzeichnet,**
**dass** innerhalb eines Schaltungszweiges eine Leuchtdiode der Vorderseite oder eine Gruppe von Leuchtdioden (LD11, LD15; LD21, LD25; LD31 LD35; LD41, LD45; LD51, LD55; LD61, LD65) der Vorderseite abwechselnd mit einer Leuchtdiode (LDi11, LDi31, LDi52) der Rückseite oder einer Gruppe von Leuchtdioden der Rückseite angeordnet sind.

6. Leiterplatte nach Anspruch 5,
**dadurch gekennzeichnet,**
**dass** die Gruppen von Leuchtdioden (LD11, LD15; LD21, LD25, LD31 LD35; LD41, LD45, LD51, LD55; LD61, LD65) innerhalb eines Schaltungszweiges eine unterschiedliche Anzahl von Leuchtdioden umfassen, wobei die Anzahl insbesondere zwei oder vier beträgt.

7. Leiterplatte nach einem der vorigen Ansprüche 5 oder 6,
**dadurch gekennzeichnet,**
**dass** einzelne Leuchtdioden (LDi11, LDi31, LDi52) oder Gruppen von Leuchtdioden mittels Null-Ohm-Widerständen (R11, R31, R52) überbrückbar sind, wobei hierfür auf der Leiterplatte elektrische Kontaktflächen zur Kontaktierung der Widerstände (R11, R31, R52) vorgesehen sind.

8. Leiterplatte nach einem der vorigen Ansprüche,
**dadurch gekennzeichnet,**
**dass** erste Gruppen von Leuchtdioden (LD11-LD18; LD21, LD25, LD23, LD24) von Schaltungszweigen (1, 2, 3, 4), welche das gleiche Spannungspotential aufweisen, in Clustern zur Abstrahlung ihres Lichtes in eine gemeinsame Optik angeordnet sind.

9. Leiterplatte nach Anspruch 8,
**dadurch gekennzeichnet,**
**dass** zweite Gruppen von Leuchtdioden (LD22, LD26, LD24, LD28) von Schaltungszweigen, welche ein Spannungspotential aufweisen, welches sich im Wesentlichen um die Vorwärtsspannung der verwendeten Leuchtdioden vom Spannungspotential der ersten Gruppe (LD21, LD25, LD23, LD24) unterscheidet, gemeinsam mit Leuchtdioden der ersten Gruppe (LD21, LD25, LD23, LD24) in Clustern zur Abstrahlung ihres Lichtes in eine gemeinsame Optik angeordnet sind.

10. Leiterplatte nach einem der vorigen Ansprüche
**dadurch gekennzeichnet,**
**dass** die Leuchtdioden (LD11, LD15; LD21, LD25; LD31 LD35; LD41, LD45; LD51, LD55; LD61, LD65; LDi11, LDi31, LDi52) weißes Licht abgeben.

11. Leiterplatte nach einem der vorigen Ansprüche
**dadurch gekennzeichnet,**
**dass** die Leuchtdioden (LD11, LD15, LD21, LD25, LD31 LD35, LD41, LD45, LD51, LD55, LD61, LD65) der ersten Anzahl 1-Chip LEDs sind und dass die Leuchtdioden (LDi11, LDi31, LDi52) der zweiten Anzahl 2-Chip LEDs sind.

12. Leuchte mit wenigstens einer Leiterplatte nach einem oder mehreren der vorigen Ansprüche.

13. Leuchte nach Anspruch 12,
**dadurch gekennzeichnet,**
**dass** die Leuchte als Anbau- oder Pendelleuchte ausgeführt ist,
wobei das Licht der ersten Anzahl von Leuchtdioden (LD11, LD15, LD21, LD25, LD31 LD35, LD41, LD45, LD51, LD55, LD61, LD65) der direkten Beleuchtung und das Licht der zweiten Anzahl von Leuchtdioden (LDi11, LDi31, LDi52) der direkten Beleuchtung dient.

## Claims

1. Printed circuit board for a luminaire,
comprising a plurality of circuit branches with a plurality of light-emitting diodes, wherein the light-emitting diodes of a circuit branch are each connected in series with one another, while the circuit branches are connected in parallel with each other, wherein a first number of light-emitting diodes (LD11, LD15, LD21, LD25, LD31 LD35, LD41, LD45, LD51, LD55, LD61, LD65) of a circuit branch are arranged on a front side of the printed circuit board, while a second number of light emitting diodes (LDi11, LDi31, LDi52) of the same circuit branch are arranged on a rear side of the printed circuit board, wherein the light emitting diodes (LD11, LD15, LD21, LD25, LD31 LD35, LD41, LD45, LD51, LD55, LD61, LD65) of a circuit branch are of the same type,
**characterized in that**
the light emitting diodes (LD11, LD15, LD21, LD25, LD31 LD35, LD41, LD45, LD51, LD55, LD61, LD65) of the first number have a voltage potential that is different from that of the light emitting diodes (LDi11, LDi31, LDi52) of the second number.

2. Printed circuit board according to claim 1,
**characterized in that**
the number of the light-emitting diodes (LD11, LD15, LD21, LD25, LD31 LD35, LD41, LD45, LD51, LD55, LD61, LD65) which are mounted on the front side of the printed circuit board is not equal to the number of the light-emitting diodes (LDi11, LDi31, LDi52) which are mounted on the rear side.

3. Printed circuit board according to claim 1 or 2,
**characterized in that**
the number of light emitting diodes (LD11, LD15, LD21, LD25, LD31 LD35, LD41, LD45, LD51, LD55, LD61, LD65) mounted on the front side of the circuit board is larger than the number of light emitting diodes (LDi11, LDi31, LDi52) mounted on the back.

4. Printed circuit board according to one of the preceding claims,
**characterized in that**
the ratio of the number of the light emitting diodes (LD11, LD15, LD21, LD25, LD31 LD35, LD41, LD45, LD51, LD55, LD61, LD65) mounted on the front side of the circuit board to the number of light emitting diodes (LDi11, LDi31, LDi52) mounted on the rear side, is 4 : 1.

5. Printed circuit board according to one of the preceding claims,
**characterized in that**
within a circuit branch, a light-emitting diode of the front side or a group of light-emitting diodes (LD11, LD15, LD21, LD25, LD31 LD35, LD41, LD45, LD51, LD55, LD61, LD65) of the front side alternate with a light emitting diode (LDi11, LDi31, LDi52) of the rear side or a group of light-emitting diodes of the rear side.

6. Printed circuit board according to claim 5,
**characterized in that**
the groups of light-emitting diodes (LD11, LD15, LD21, LD25, LD31 LD35, LD41, LD45, LD51, LD55, LD61, LD65) within a circuit branch comprise a different number of light-emitting diodes, wherein the number is two or four.

7. Printed circuit board according to one of the preceding claims 5 or 6,
**characterized in that**
individual light-emitting diodes (LDi11, LDi31, LDi52) or groups of light-emitting diodes may be bridged by means of zero-ohm resistors (R11, R31, R52), wherein electrical contact surfaces are provided on the printed circuit board to contact the resistors (R11, R31, R52).

8. Printed circuit board according to one of the preceding claims,
**characterized in that**
first groups of light-emitting diodes (LD11-LD18; LD21, LD25, LD23, LD24) of circuit branches (1,2,3,4) having the same voltage potential, are arranged in clusters for emitting their light in a common optical system.

9. Printed circuit board according to claim 8,
**characterized in that**
second groups of light-emitting diodes (LD22, LD26, LD24, LD28) of circuit branches which have one voltage potential that essentially differs by the forward voltage drop of the light-emitting diodes used from the voltage potential of the first group (LD21, LD25, LD23, LD24), are arranged in clusters with light-emitting diodes of the first group (LD21, LD25, LD23, LD24) for emitting their light in a common optical system.

10. Printed circuit board according to one of the preceding claims,
**characterized in that**
the light-emitting diodes (LD11, LD15, LD21, LD25, LD31 LD35, LD41, LD45, LD51, LD55, LD61, LD65, LDi11, LDi31, LDi52) emit white light.

11. Printed circuit board according to one of the preceding claims,
**characterized in that**
the light-emitting diodes (LD11, LD15, LD21, LD25, LD31 LD35, LD41, LD45, LD51, LD55, LD61, LD65) of the first number are 1-chip LEDs, and that the light-emitting diodes (LDi11, LDi31, LDi52) of the second number are 2-chip LEDs.

12. Luminaire with at least one printed circuit board according to one or more of the preceding claims.

13. Luminaire according to claim 12,
**characterized in that**
the luminaire is designed as a surface-mounted or pendant lamp, wherein the light of the first number of light emitting diodes (LD11, LD15, LD21, LD25, LD31 LD35, LD41, LD45, LD51, LD55, LD61, LD65) serves for direct lighting and the light of the second number of light emitting diodes (LDi11, LDi31, LDi52) serves for direct lighting.

## Revendications

1. Carte de circuit imprimé pour une lampe,
présentant plusieurs branches de circuit avec une multiplicité de diodes électroluminescentes, les diodes électroluminescentes d'une branche de circuit étant montées respectivement en série les unes avec les autres, et les branches de circuit étant raccordées en parallèles les unes avec les autres, un première nombre de diodes électroluminescentes (LD11, LD15, LD21, LD25, LD31, LD35, LD41, LD45, LD51, LD55, LD61, LD65) d'une branche de circuit étant mises en place sur un côté avant de la carte de circuit imprimé, et un deuxième nombre de diodes électroluminescentes (LDi11, LDi31, LDi52) de la même branche de circuit étant mises en place sur un côté arrière de la carte de circuit imprimé,
les diodes électroluminescentes (LD11, LD15, LD21, LD25, LD31, LD35, LD41, LD45, LD51, LD55, LD61, LD65) d'une branche de circuit étant du même type, **caractérisée en ce que** les diodes électroluminescentes (LD11, LD15, LD21, LD25, LD31, LD35, LD41, LD45, LD51, LD55, LD61, LD65) du premier nombre présentent une classification de tension différente des diodes électroluminescentes (LDi11, LDi31, LDi52) du deuxième nombre.

2. Carte de circuit imprimé selon la revendication 1,
**caractérisée en ce que**
le nombre de diodes électroluminescentes (LD11, LD15, LD21, LD25, LD31, LD35, LD41, LD45, LD51, LD55, LD61, LD65) qui sont mises en place sur le côté avant de la carte de circuit imprimé diffère du nombre de diodes électroluminescentes (LDi11, LDi31, LDi52) qui sont mises en place sur le côté arrière.

3. Carte de circuit imprimé selon la revendication 1 ou 2,
**caractérisée en ce que**
le nombre de diodes électroluminescentes (LD11, LD15, LD21, LD25, LD31, LD35, LD41, LD45, LD51, LD55, LD61, LD65) qui sont mises en place sur le côté avant de la carte de circuit imprimé est plus élevé que le nombre de diodes électroluminescentes (LDi11, LDi31, LDi52) qui sont mises en place sur le côté arrière.

4. Carte de circuit imprimé selon l'une des revendications précédentes,
**caractérisée en ce que**
le rapport du nombre de diodes électroluminescentes (LD11, LD15, LD21, LD25, LD31, LD35, LD41, LD45, LD51, LD55, LD61, LD65) qui sont mises en place sur le côté avant de la carte de circuit imprimé au nombre de diodes électroluminescentes (LDi11, LDi31, LDi52) qui qui sont mises en place sur le côté arrière est égal à 4:1.

5. Carte de circuit imprimé selon l'une des revendications précédentes,
**caractérisée en ce que**,
à l'intérieur d'une branche de circuit, une diode électroluminescente du côté avant ou un groupe de diodes électroluminescentes (LD11, LD15 ; LD21, LD25 ; LD31, LD35 ; LD41, LD45 ; LD51, LD55 ; LD61, LD65) du côté avant sont disposés de façon alternée avec une diode électroluminescente (LDi11, LDi31, LDi52) du côté arrière ou avec un groupe de diodes électroluminescentes du côté arrière.

6. Carte de circuit imprimé selon la revendication 5,
**caractérisée en ce que**
les groupes de diodes électroluminescentes (LD11, LD15 ; LD21, LD25, LD31, LD35 ; LD41, LD45, LD51, LD55 ; LD61, LD65) à l'intérieur d'une branche de circuit comprennent un nombre différent de diodes électroluminescentes, le nombre étant en particulier égal à deux ou quatre.

7. Carte de circuit imprimé selon l'une des revendications précédentes 5 ou 6,
**caractérisée en ce que**
des diodes électroluminescentes (LDi11, LDi31, LDi52) individuelles ou des groupes de diodes électroluminescentes peuvent être shuntés au moyen de résistances de zéro ohm (R11, R31, R52), des surfaces de contact électriques destinées à la mise en contact des résistances (R11, R31, R52) étant prévues pour cela sur la carte de circuit imprimé.

8. Carte de circuit imprimé selon l'une des revendications précédentes,
**caractérisée en ce que**
des premiers groupes de diodes électroluminescentes (LD11-LD18 ; LD21, LD25, LD23, LD24) de branches de circuit (1, 2, 3, 4) qui présentent le même potentiel de tension sont disposés dans des clusters pour le rayonnement de leur lumière vers une optique commune.

9. Carte de circuit imprimé selon la revendication 8,
**caractérisée en ce que**
des deuxièmes groupes de diodes électroluminescentes (LD22, LD26, LD24, LD28) de branches de circuit qui présentent un potentiel de tension dont la différence par rapport au potentiel de tension du premier groupe (LD21, LD25, LD23, LD24) est essentiellement égale à la tension directe des diodes électroluminescentes utilisées sont disposés conjointement avec des diodes électroluminescentes du premier groupe (LD21, LD25, LD23, LD24) dans des clusters pour le rayonnement de leur lumière vers une optique commune.

10. Carte de circuit imprimé selon l'une des revendications précédentes,
**caractérisée en ce que**
les diodes électroluminescentes (LD11, LD15 ; LD21, LD25 ; LD31 LD35 ; LD41, LD45 ; LD51, LD55 ; LD61, LD65 ; LDi11, LDi31, LDi52) émettent de la lumière blanche.

11. Carte de circuit imprimé selon l'une des revendications précédentes,
**caractérisée en ce que** les diodes électroluminescentes (LD11, LD15, LD21, LD25, LD31, LD35, LD41, LD45, LD51, LD55, LD61, LD65) du premier nombre sont des LED mono-puces, et **en ce que** les diodes électroluminescentes (LDi11, LDi31, LDi52) du deuxième nombre sont des LED bi-puces.

12. Lampe avec au moins une carte de circuit imprimé selon l'une ou plusieurs des revendications précédentes.

13. Lampe selon la revendication 12,
**caractérisée en ce que**
la lampe est réalisée en tant que lampe en applique ou lampe suspendue,
la lumière du premier nombre de diodes électroluminescentes (LD11, LD15, LD21, LD25, LD31, LD35, LD41, LD45, LD51, LD55, LD61, LD65) servant à l'éclairage direct et la lumière du deuxième nombre de diodes électroluminescentes (LDi11, LDi31, LDi52) servant à l'éclairage direct.
